Europäisches Patentamt

European Patent Office

Office européen des brevets

(19)

(11) Publication number: **0 056 186**
A2

(12)

# EUROPEAN PATENT APPLICATION

(21) Application number: **81305990.4**

(22) Date of filing: **21.12.81**

(51) Int. Cl.³: **H 01 L 21/70,** H 01 L 23/52, H 01 L 27/06, H 03 K 19/092

(30) Priority: **08.01.81 US 223451**

(71) Applicant: **TEXAS INSTRUMENTS INCORPORATED, 13500 North Central Expressway, Dallas Texas 75265 (US)**

(43) Date of publication of application: **21.07.82 Bulletin 82/29**

(72) Inventor: **Sloan, Benjamin J., 1709 Homestead, Garland Texas 75265 (US)**
Inventor: **De Jong, Glenn A., 1244 Houston Drive, Melbourne Florida 32935 (US)**

(74) Representative: **Abbott, David John et al, Abel & Imray Northumberland House 303-306 High Holborn, London, WC1V 7LH (GB)**

(84) Designated Contracting States: **DE FR GB NL**

(54) Integrated circuit device with interconnect-level logic diodes.

(57) Logic circuitry is implemented in a semiconductor device using decoupling diodes formed between active areas at or between levels of interconnect formed above a monocrystalline semiconductor substrate. Schottky transistor logic and other forms of bipolar logic can be fabricated with significant area reductions using output-decoupling diodes disposed at sites which are remote from the output nodes corresponding logic-gates.

EP 0 056 186 A2

## INTEGRATED CIRCUIT DEVICE WITH INTERCONNECT-LEVEL LOGIC DIODES

The present invention pertains to semiconductor integrated circuit devices and has for a principal object the provision of improved device structures and methods of fabrication.

The dramatic reduction in the cost of semiconductor devices in recent years is attributable in part to the development of techniques for increasing the density of circuit elements on a single semiconductor chip or bar. The technology for producing such high density complex circuitry is commonly referred to as very large scale integration or VLSI. The present invention enables significant increases in circuit density and is therefore particularly useful in the manufacture of VLSI devices. Although the invention has broad application in the art, it will be described herein in the context of a bipolar logic circuit application.

Typical integrated circuit layouts are comprised of active areas or islands in which elements such as diodes and transistors are fabricated and other areas which are consumed primarily by the leads or interconnect between elements in different active areas. The percent of the total bar area consumed by interconnect depends on various factors including the number of active element groups as well as the technology and circuit type (logic versus memory, for example).

Certain forms of bipolar logic in which the basic gate or logic unit has a single input and multiple outputs tend to be less efficient in terms of percent active area than conventional multiple-input logic forms. An example of a common form of multiple-output bipolar logic is Schottky transistor logic (STL) in which Schottky barrier diodes decouple the outputs from the collector of a logic-gate transistor. Those skilled in the art will appreciate that STL circuits frequently require the routing of several of the multiple-output leads to remote points such that significant bar area is devoted to multiple (often parallel) interconnect leads running from a single gate. It would be desirable to substitute a single interconnect lead for such multiple interconnect leads and decouple the outputs at or near the remote points where they interconnect with other gates. In one technique employed in the prior art, decoupling diodes are provided in remote islands and a single metal lead is used to connect each island to the collector of a corresponding logic-gate transistor. Such isolated outputs do conserve the interconnect area but also increase the number of islands and compromise performance by virtue of the added parasitic capacitance of the remote islands.

It is therefore an important object of the present invention to provide a technique for forming decoupling diodes which require no additional islands, do not add parasitic capacitance, and can be placed at the most convenient location in the circuit so as to minimize the area devoted to interconnect.

In accordance with the present invention, decoupling diodes are formed at an interconnect level above a monocrystalline semiconductor body, the decoupling diodes being fabricated in or between conductive layers extending between active areas. Several ways of carrying out the invention will now be described with reference to the accompanying drawings in

Figures 1-4 are vertical cross sections schematically depicting four of many different possible diode structures in accordance with the present invention;

Figure 5 is a vertical cross section of a portion of a semiconductor device in accordance with one practical application of the present invention which employs interconnect-level diodes of the type shown in Figure 3;

Figure 6 is a circuit diagram of the structure shown in Figure 5;

Figure 7 is a plan view of a portion of a logic circuit implemented using conventional interconnect techniques; and

Figure 8 is a plan view of a portion of a logic circuit in accordance with the present invention for performing the same logic operation as the circuit portion of Figure 7.

In the description which follows, similar referenced numerals designate similar elements in the various figures.

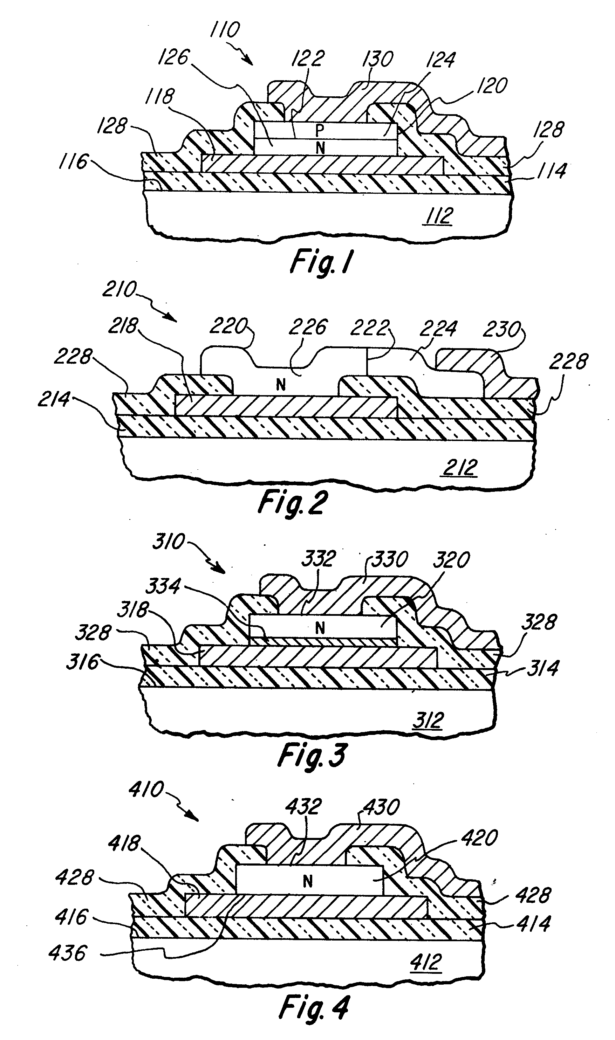

Figure 1 illustrates a portion of a semiconductor device including one embodiment of a decoupling diode according to the invention. The decoupling diode is designated generally by reference numeral 110 and is formed above a body of monocrystalline semiconductor material 112 which might be a conventional semiconductor substrate or an epitaxial layer formed on a semiconductor substrate. The diode 110 is insulated from the body 112 in a conventional manner such as by means of an oxide layer 114 grown on an upper surface 116 of the body. A first conductor 118 is formed atop the insulating layer 114. The first conductor 118 preferably comprises a metal such as aluminum which can be readily deposited and patterned but alternatively might comprise other conductive materials such as polycrystalline silicon which is heavily doped with impurities so that it exhibits a negligible resistivity.

A site of a decoupling diode is provided by a layer 120 of semiconductor material within which a PN junction 122 is formed. Preferably, the layer 120 is formed by depositing N-type polycrystalline silicon which is then recrystallized, patterned, and doped with acceptor impurities to define a P-type anode region 124 above an N-type cathode region 126. A second oxide layer 128 overlies the first conductor 118 and the periphery of the semiconductor layer 120. A second conductor 130 overlies the second oxide layer 128 and extends through a window therein to make ohmic contact with the semiconductor layer 120. Those skilled in the art will appreciate that the decoupling diode 110 can be fabricated at any convenient location in a semiconductor device and that the vertically stacked structure of Figure 1 requires minimal device area.

The preferred method of forming the decoupling diode 110 is as follows. After forming the oxide layer 114 on the upper surface 116 between the various active regions (not shown) in the semiconductor body 112, a metal layer is deposited and patterned to provide a first-level interconnect network which includes the lead 118. N-type polycrystalline silicon is then deposited in a suitable manner such as by conventional CVD hot wall or plasma deposition techniques. Preferably, the polycrystalline silicon is then laser annealed to crystallographically reorder the silicon to provide a substantially monocrystalline silicon layer. Conventional selective etching techniques are then used to pattern the silicon to provide a plurality of separate silicon layers such as the layer 120. At this stage or prior to patterning of

silicon, an acceptor diffusion is performed to form the P-type region 124 which defines the PN junction 122 with the underlying N-type region 126. The second oxide layer 128 is then deposited and patterned to provide a contact window to the upper surface of the P-type region 124. Next, a metal layer is deposited and patterned to provide a second-level interconnect network which includes the lead 130. Conventional processing steps follow in order to complete the device structure, such processing steps including, for example, the formation of a glass passivation layer (not shown) over the second oxide layer 128 and second-level interconnect network.

Referring to Figure 2, a second embodiment of a decoupling diode 210 according to the invention will be described. The structure of the diode 210 requires more lateral but less vertical space than the previously described diode 110. More importantly, the diode 210 is less sensitive to diffusion processing and is therefore presently regarded as more practicable than the diode 110. The diode 210 is formed above a semiconductor body 212 which includes logic gates formed in active areas (not shown). First and second oxide layers 214 and 228, a silicon layer 220, and first and second conductors 218 and 230 are formed using essentially the same processing steps used to fabricate the diode 110 of Figure 1. However, in the case of the diode 210 of Figure 2, a PN junction 222 is defined between laterally spaced anode and cathode regions 224 and 226, the anode region 224 being formed by masking the cathode region 226 and diffusing acceptor impurities such as boron into the anode region prior to forming the second conductor 230. Conversely, if the silicon layer 220 is initially P-type material, the cathode region 226 can be formed by masking the anode region 224 and diffusing donor impurities such as phosphorus into the cathode region.

Referring to Figure 3, a third embodiment of a decoupling diode 310 according to the invention will be described. The structure of the diode 310 is geometrically similar to the diode 110 of Figure 1. The diode 310 is constructed on an oxide layer 314 grown on the upper surface 316 of a semiconductor body 312. The diode 310 comprises a silicon layer 320 disposed between conductors 318 and 330 which are insulated from each other by an oxide layer 328. Instead of forming a PN junction within the silicon layer as in the structure of Figure 1, a Schottky barrier 332 is formed at the interface of the silicon layer 320 and the conductor 330. The Schottky barrier 332 can be formed using conventional techniques such as by sintering platinum into the upper surface of the silicon layer 320 prior to depositing aluminum to form the conductor 330. An ohmic contact 334 is formed between the conductor 318 and the silicon layer 320 in a suitable manner such as by providing a relatively high concentration of impurities in the silicon layer 320 at its interface with the conductor 318. Thus, conductor 330 forms the anode connection and conductor 318 forms the cathode connection of the diode 310. It will be understood that it is also possible to form a Schottky barrier between the silicon layer 320 and the lower-level conductor 318 and form an ohmic contact between the silicon layer 320 and the upper-level conductor 330 which provides a diode in the reverse direction from that depicted in Figure 3.

Referring to Figure 4, a fourth embodiment of a decoupling diode 410 according to the invention will be described. The diode 410 is geometrically similar to the previously described diode 310 except that two Schottky barrier diodes are formed instead of one. The diode 410 is constructed on an oxide layer 414 grown on the upper surface 416 of a semiconductor body 412. The diode 410 comprises a silicon layer 420 disposed between conductors 418 and 430 which are insulated from each other by an oxide layer 428. Formed at the conductor-silicon interfaces are Schottky barrier diodes 432 and 436, the silicon layer 420 forming a common cathode and the conductors 418 and 430 forming anode connections. The practical applications of such a structure will be apparent. For example, by causing the diodes 432 and 436 to have different barrier heights, one diode can serve as a decoupling diode and the other as a clamp diode for a logic-gate transistor (not shown). It will be appreciated that such different Schottky barrier heights can be achieved by means of different metals or by different impurity doping levels at the conductor-silicon interfaces.

From the foregoing it will be recognized that interconnect-level diodes in accordance with the present invention can assume many different structural configurations and can be fabricated using various different techniques. The invention as defined in the appended claims contemplates other structures and fabrication techniques beyond those expressly shown and described above. For example, it is contemplated that diodes suitable for memory or logic operations can be fabricated using barrier-forming materials other than silicon which are known in the solid state rectifier art. It is contemplated that an array of diode sites in which diodes such as the diode 210 may or may not be formed can be used to fabricate a read only memory (ROM) wherein the presence of a diode indicates a stored "1" and the absence of a diode indicates a stored "0".

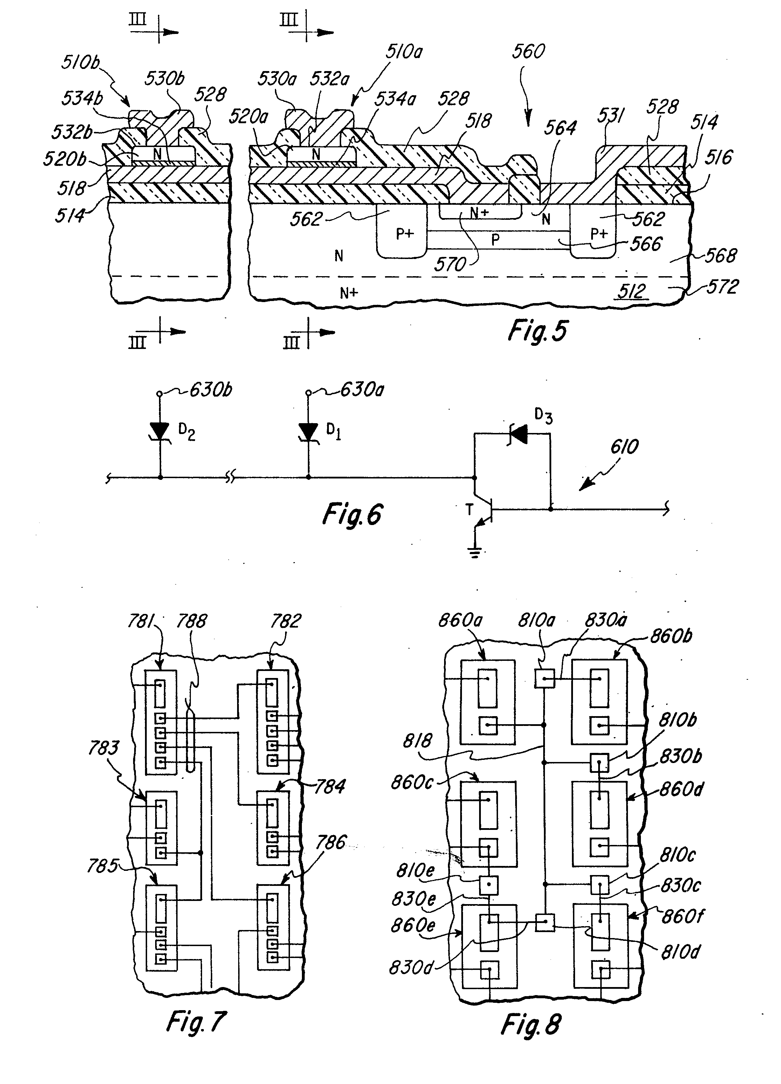

Now referring to Figure 5, the preferred structure of a semiconductor device according to the present invention will be

0056186

described. One of a plurality of logic gates is shown and designated generally by reference numeral 560. The logic gate 560 fans out to several decoupling diodes which can be fabricated proximate to or remote from the logic gate as exemplified by the decoupling diodes 510a and 510b. The decoupling diodes preferably are Schottky barrier diodes fabricated like the previously described diode 310. The logic gate 560 is formed along the upper surface 516 of a monocrystalline semiconductor body 512 within an active area laterally confined by a P+ isolation region 562. The invention contemplates similar structures using conventional oxide isolation, buried-collector techniques. The logic gate 560 comprises an NPN transistor constructed in common emitter configuration with like logic-gate transistors in other active areas (not shown). The NPN transistor comprises an N-type collector region 564, a P-type base region 566 and an N-type emitter region 568. A conductor 518 makes low resistance contact to an N+ region 570 which defines the collector contact or output node of the logic gate 560. A large underlying N+ region 572 provides a ground connection to the emitter 568 as well as the emitters of other logic-gate transistors (not shown). The conductor 518 forms part of a first-level interconnect network and extends along an oxide layer 514 from the logic gate 560 to a group of diode sites where decoupling diodes such as diodes 510a and 510b are formed. The decoupling diodes have annealed (preferably by means of a pulse laser) silicon layers 520a and 520b which form Schottky barriers 532a and 532b with respective conductors 530a and 530b of a second-level interconnect network. The conductors 530a and 530b extend along the top surface of a second oxide layer 528 to other points of a logic circuit, such as the inputs of other logic gates. Another conductor 53

illustrates by way of example the manner in which a conductor of the second-level interconnect network makes contact to the input of logic gate 560. The conductor 531 makes ohmic contact to the $P^+$ region 562 which defines the base contact or input node of the logic gate 560. The conductor 531 also makes a Schottky barrier contact to the N-type region 564 to form a diode clamp across the collector-base junction of the logic-gate transistor.

An equivalent circuit 610 of the integrated circuit portion of Figure 5 is shown in Figure 6. The circuit includes NPN transistor T with Schottky barrier diodes $D_1$ and $D_2$ on its collector and a Schottky barrier diode $D_3$ shunting its collector-base junction as shown. The diodes $D_1$ and $D_2$ provide decoupled terminals 630a and 630b corresponding to the conductors 530a and 530b of Figure 5. Those skilled in the art will recognize that the circuit of Figure 6 resembles a conventional STL logic gate except with decoupling diodes $D_1$ and $D_2$ disposed remote from the logic-gate transistor T.

In order to convey an appreciation for the economies of scale and the flexibility provided by the invention, a portion of a logic circuit is implemented using conventional STL techniques in Figure 7 and using the inventive technique in Figure 8. In the circuit of Figure 7 there are six logic gates 781, 782, 783, 784, 785 and 786 disposed in active areas or islands depicted as relatively large rectangles. Each of the logic gates has an input terminal depicted as a relatively small rectangle and a plurality of decoupled output terminals depicted as squares. One level of interconnect designated generally by reference numeral 788 may be used to make all the connections between logic gates. In this example, three of the outputs of logic gate 781 are connected via the interconnect 788 to the inputs of logic gates 782, 784 and 786. The remaining output of logic gate 781 is connected via the interconnect 788 to the second of two outputs of logic gate 783 and the input of logic gate 785. A second level of interconnect (not shown) is ordinarily used to provide certain other connections such as voltage source connections. Other portions of the interconnect 788 extend between the logic gates 781-786 and portions of the circuit not shown in the drawing. Since each output in the circuit of Figure 7 is decoupled by a Schottky barrier diode (square-shaped elements) formed within the active area of the corresponding logic gate, it is necessary to provide a separate conductor for each output from a logic gate. The present invention decouples the outputs at points which are remote from the logic gates that drive the outputs so that only a single output conductor (although more could be provided) is required of each logic gate as will become apparent upon studying the layout of Figure 8.

With particular reference now to Figure 8, six logic gates, 860a, 860b, 860c, 860d, 860e and 860f are disposed in active areas or islands depicted by the relatively large rectangular shapes. Each logic gate has an input node (small rectangles) and an output node (squares within large rectangles) which correspond respectively to the base and collector of the logic-gate transistor T of Figure 6. Decoupling diodes 810a, 810b, 810c, 810d and 810e are disposed at sites located between active areas. A conductor 818 which is in contact with the output node of logic gate 860a extends to and makes electrical connections with the cathodes of diodes 810a, 810b, 810c, and 810d. Conductor 818 is one of a plurality of similar conductors which extend from the output nodes of the various logic gates and form part of a first-level interconnect network. Conductors of a second-level interconnect network include conductor 830a connecting the anode of diode of 810a to the input node of logic gate 860b, conductor 830b connecting the anode of diode 810b to the input node of logic gate 860d, conductor 830c connecting the anode of diode 810c to the input node of logic gate 860f, conductor 830d connecting the anode of diode 810d to the input node of logic gate 860e and conductor 830e connecting the anode of diode 810e to the input node of logic gate 860e.

It will be appreciated that the circuit portion shown in Figure 8 performs essentially the same logic operation as the circuit portion shown in Figure 7, thus demonstrating that the present invention achieves a significant area reduction due both to the smaller active areas and the reduced area devoted to interconnect. Various logic circuits such as the circuits shown in Figure 8 can be implemented using the previously described structures as well as functionally equivalent structures as will be appreciated by those skilled in the art. For example, the logic gate 860a of Figure 8 can be implemented using the transistor structure 560 of Figure 5. Likewise, the decoupling diodes 810a, 810b, etc, can be implemented using diode structures like those designated by reference numerals 510a and 510b in Figure 5 or by functionally equivalent diode structures such as previously described diodes 110 and 210.

Although the invention has been described using specific examples, it will be understood that various alterations and modifications are within the spirit and scope of the invention as defined in the appended claims.

0056186

WHAT IS CLAIMED IS:

1.      A semiconductor device comprising:

a body of monocrystalline semiconductor material;

a plurality of isolated active areas defined within the body, selected active areas each having a logic gate defined by an input node, an output node, and transistor means for generating an amplified inverted logic signal at the output node in response to a logic signal at the input node;

a plurality of diode sites disposed between active areas above and insulated from the body, a decoupling diode formed in each diode site, each decoupling diode having an anode and a cathode;

a plurality of first conductors, each first conductor being in contact with the output node of a corresponding logic gate and extending to a group of diode sites to make electrical connection with the cathodes of the decoupling diodes formed therein; and

a plurality of second conductors, each second conductor being in contact with the input node of a corresponding logic gate and extending to at least one diode site to make electrical connection with the anode of the decoupling diode formed therein.

2.      The semiconductor device of Claim 1 wherein the first and second conductors comprise aluminum and the decoupling diodes comprise annealed silicon layers disposed between corresponding first and second conductors.

3.      The semiconductor device of Claim 2 wherein the anodes of the decoupling diodes comprise P-type regions and the cathodes of the decoupling diodes comprise N-type regions in the silicon layers.

4.      The semiconductor device of Claim 3 wherein the anode and cathode regions of each decoupling diode are disposed in a vertically stacked arrangement in the silicon layer.

5.      The semiconductor device of Claim 3 wherein the anode and cathode regions of each decoupling diode are laterally adjacent regions in the silicon layer.

6.      The semiconductor device of Claim 2 wherein the silicon layer forms a Schottky barrier diode with the second conductor.

7.      The semiconductor device of Claim 1 further comprising a first insulating layer formed on an upper surface of the body between active areas, the first conductors overlying the first insulating layer, and further comprising a second insulating layer overlying the first insulating layer and the first conductors, the second conductors overlying the second insulating layer.

8.      The semiconductor device of Claim 7 wherein the decoupling diodes comprise silicon layers lying between overlapping portions of respective first and second conductors.

9.      A method of making a semiconductor device comprising:
        defining active areas in a body of monocrystalline semiconductor material;
        forming transistors in selected active areas;
        forming a first insulating layer atop an upper surfac

of the body;

depositing a first conductive layer over the first insulating layer and through openings in the first insulating layer to contact nodes of transistors;

selectively removing portions of the first conductive layer to form a first interconnect network;

depositing a layer of polycrystalline semiconductor material;

annealing the polycrystalline semiconductor material to reorder the crystallographic structure thereof to provide an essentially monocrystalline structure;

selectively removing portions of the deposited semiconductor material to leave a pattern of discrete semiconductor layers at predetermined sites in the device;

forming diodes in the deposited semiconductor material at the predetermined sites;

depositing a second insulating layer on the device;

selectively removing portions of the second insulating layer to provide contact windows to the diodes and transistors;

depositing a second conductive layer on the device; and

selectively removing portions of the second conductive layer to form a second interconnect network for interconnecting the diodes and transistors in a predetermined manner.

10.    A method of making an integrated circuit device comprising:

forming a first insulating layer above a supporting substrate;

depositing a layer of semiconductor material over the first insulating layer;

annealing the semiconductor layer to reorder the crystallographic structure thereof;

forming diodes in predetermined diode sites in the semiconductor layer;

forming a patterned second insulating layer having contact windows to the diodes; and

forming a conductive network for interconnecting the diodes to define a circuit portion of the integrated circuit device.

Fig. 1

Fig. 2

Fig. 3

Fig. 4

0056186

Fig.5

Fig.6

Fig.7

Fig.8